# EUROPEAN PATENT APPLICATION

(11) **EP 3 846 343 A1**
(43) Date of publication of application: **07.07.2021**
(21) Application number: 19855203.6
(22) Date of filing: 01.08.2019
(51) Int. Cl.: H03H 9/25, H01L 41/187, H01L 41/312, H03H 3/08

(54) **COMPOSITE SUBSTRATE AND METHOD OF MANUFACTURING COMPOSITE SUBSTRATE**

(30) Priority: 30.08.2018 JP 2018161627
(71) Applicant: SHIN-ETSU CHEMICAL CO., LTD., Tokyo 100-0004 (JP)
(72) Inventor: AKIYAMA, Shoji, Annaka-shi, Gunma 379-0195 (JP)
(74) Representative: Vossius & Partner Patentanwälte Rechtsanwälte mbB
(86) International application number: PCT/JP2019/030137
(87) International publication number: WO 2020/044925

(57) **Abstract**

A composite substrate with suppressed pyroelectricity increase due to the heat-treatment process is provided. The composite substrate has an oxide single crystal thin film, which is a single crystal thin film of a piezoelectric material, a support substrate, and a diffusion prevention layer that is provided between the oxide single crystal thin film and the support substrate to prevent the diffusion of oxygen. The diffusion prevention layer may have any of silicon oxynitride, silicon nitride, silicon oxide, magnesium oxide, spinel, titanium nitride, tantalum, tantalum nitride, tungsten nitride, aluminum oxide, silicon carbide, tungsten boron nitride, titanium silicon nitride, and tungsten silicon nitride.

## Description

### Technical Field

The present invention relates to a composite substrate for surface acoustic wave devices and a method for manufacturing the same.

### Background Art

In recent years, in the field of mobile communications typified by smartphones, data traffic has been increased. As the number of required bands increases to cope with the increase in communication volume, there is a need for higher performance Surface Acoustic Wave (SAW) devices used as filters.

Piezoelectric materials such as Lithium Tantalate (LiTaO₃, hereafter abbreviated as "LT") and Lithium Niobate (LiNbO₃, hereafter abbreviated as "LN") are widely used as materials for surface acoustic wave devices. There is a technology to improve the temperature characteristics of the surface acoustic wave devices by bonding one side of the substrate of such piezoelectric material to a support substrate such as sapphire, and thinning the other side of the bonded LT substrate (or LN substrate) to a few to tens of micrometers by grinding (see, for example, Non-Patent Document 1).

Further, in such a surface acoustic wave device by bonding, there is a technology to reduce noise components called ripple by adding an intervening layer (adhesive layer) between the thinned LT layer (or LN layer) and the support substrate (see, for example, Non-Patent Document 2). The material of the interposition layer is preferably a material having high insulating properties, low high-frequency loss (low dielectric loss), and easy processing (for example, planarization). For example, metal oxides such as SiO₂, TiO₂, Ta₂O₅, Nb₂O₅, and ZrO₂ are often used for intervening layer as materials with such properties.

There is also a technique to treat LT (or LN) in a reducing atmosphere to reduce the pyroelectricity of piezoelectric materials and give the materials a slight conductivity (see, for example, Non-Patent Document 3). However, when surface acoustic wave devices are manufactured using composite substrate wafers with LT (or LN) bonded to a support substrate with enhanced conductivity in this way, the resistivity of the LT (or LN) layer may increase and become pyroelectric as it undergoes heat treatment in the wafer process and device process. Wafers with increased pyroelectricity are likely to polarize and charge the LT layer (or LN layer) when subjected to large temperature differences. In addition, temperature changes during the process can cause charges to accumulate on the surface of the composite substrate. If sparks occur, the pattern formed on the substrate surface is destroyed, resulting in lower yields in the device manufacturing process.

### Prior Art References

### Non-Patent Documents

Non Patent Document 1: Temperature Compensation Technology for SAW-Duplexer Used in RF Front End of Smartphone, Dempa Shimbun High Technology, Nov. 8, 2012
Non Patent Document 2: Kobayashi, "A study on Temperature-Compensated Hybrid Substrates for Surface Acoustic Wave Filters", 2010 IEEE International Ultrasonic Symposium Proceedings, October 2010, pp. 637-640.
Non-patent document 3: Yan,"Formation mechanism of black LiTaO3 single crystals through chemical reduction," Journal of Applied Crystallography (2011) 44 (1), February 2011, pp.158-162.

### Summary of the Invention

### Problems to be Solved by the Invention

In view of the above problem, it is an object of the present invention to provide a composite substrate in which the increase in pyroelectricity caused by the heat-treatment process is suppressed.

### Means for Solving the Problems

By providing a diffusion prevention layer that prevents diffusion of oxygen between an LT layer (or LN layer) and a support substrate in a composite substrate, the increase in pyroelectricity is suppressed. The inventor found that the oxygen contained in the intervening layer or the support substrate diffuses into the LT layer (or LN layer) by heat treatment, which increases the resistivity of the LT layer (or LN layer) and makes it more pyroelectric. The present invention prevents excessive oxygen diffusion into the LT layer (or LN layer) of the composite substrate by providing a diffusion prevention layer between the LT layer (or LN layer) and the intervening layer, or by forming the intervening layer with a material that has a diffusion prevention effect. In this way, the increase in pyroelectricity of the LT layer (or LN layer) of the composite substrate is suppressed.

The composite substrate of an embodiment of the present invention has an oxide single crystal thin film, which is a single crystal thin film of a piezoelectric material, a support substrate, and a diffusion prevention layer that is provided between the oxide single crystal thin film and the support substrate to prevent the diffusion of oxygen.

In the present invention, the support substrate may contain oxygen. In addition, in the present invention, an intervening layer containing oxygen may be provided between the support substrate and the diffusion prevention layer. The intervening layer may contain any of silicon dioxide, titanium dioxide, tantalum pentoxide, niobium pentoxide, and zirconium dioxide.

In the present invention, the diffusion prevention layer may have any of silicon oxynitride, silicon nitride, silicon oxide, magnesium oxide, spinel, titanium nitride, tantalum, tantalum nitride, tungsten nitride, aluminum oxide, silicon carbide, tungsten boron nitride, titanium silicon nitride, and tungsten silicon nitride.

In the present invention, the piezoelectric material may be lithium tantalate or lithium niobate.

In the present invention, the support substrate may be any of a silicon wafer, a sapphire wafer, an alumina wafer, a glass wafer, a silicon carbide wafer, an aluminum nitride wafer, and a silicon nitride wafer.

The method of manufacturing a composite substrate according to an embodiment of the present invention is characterized by a step of depositing a diffusion prevention layer on one side of a substrate of piezoelectric material, a step of bonding a support substrate on the diffusion prevention layer, and a step of thinning the substrate of piezoelectric material by grinding and polishing the other side of the substrate.

In the present invention, it is preferable that the diffusion prevention layer is deposited by PVD or CVD methods.

In the present invention, the step of depositing an intervening layer on the bonding surface of the diffusion prevention layer and/or the bonding surface of the support substrate is further provided prior to the step of bonding, and in the step of bonding, the bonding surfaces on which the intervening layer has been deposited may be bonded together.

In the present invention, the bonding surface of the diffusion prevention layer and/or the bonding surface of the support substrate may be applied with surface activation treatment and then bonded to each other. The surface activation treatment may include any one of a plasma activation method, an ion beam activation method, and an ozone water activation method.

### Brief Description of the Drawings

FIG. 1 is a cross-sectional view of the first aspect of the cross-sectional structure of the composite substrate.
FIG. 2 is a cross-sectional view of the second aspect of the cross-sectional structure of the composite substrate.
FIG. 3 shows the procedure for manufacturing the composite substrate.

### Description of Embodiments

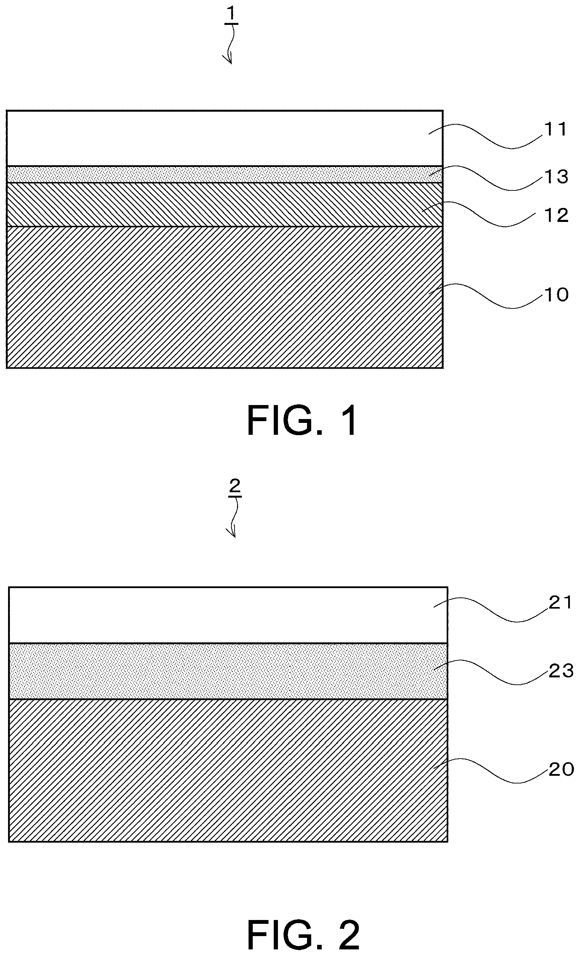

The first aspect of the cross-sectional structure of the composite substrate according to the present invention is shown in FIG. 1 (composite substrate 1).

The composite substrate 1 shown in FIG. 1 has an oxide single crystal thin film 11 on a support substrate 10, and the oxide single crystal thin film 11 is bonded to the support substrate 10 via an intervening layer 12. Then, a diffusion prevention layer 13 is provided between the oxide single crystal thin film 11 and the intervening layer 12 to prevent the diffusion of oxygen.

The oxide single crystal thin film 11 is a single crystal thin film formed of piezoelectric materials such as LT and LN. The conductivity of the oxide single crystal thin film 11 is enhanced by reducing atmosphere treatment or the like. As these piezoelectric materials, those having bulk conductivity of 1 × 10⁻¹¹ / Qcm or more are preferably used (in the case of a general material having low conductivity, the conductivity is 2 × 10⁻¹⁵ / Qcm or less).

As the support substrate 10, a silicon wafer, a sapphire wafer, an alumina wafer, a glass wafer, a silicon carbide wafer, an aluminum nitride wafer, a silicon nitride wafer, or the like can be used.

The intervening layer 12 is a layer provided between the oxide single crystal thin film 11 and the support substrate 10 when they are bonded together. Silicon oxide (e.g., silicon dioxide), titanium oxide (e.g., titanium dioxide), tantalum oxide (e.g., tantalum pentoxide), niobium oxide (e.g., niobium pentoxide), and zirconium oxide (e.g., zirconium dioxide) can be used as materials for the intervening layer 12. The intervening layer 12 can be formed using common methods such as physical vapor deposition (PVD) and chemical vapor deposition (CVD). These materials do not necessarily have to be stoichiometric compositions such as SiO₂, TiO₂, Ta₂O₃, Nb₂O₃, and ZrO₂, respectively.

Silicon oxynitride (SiON) or silicon nitride (SiN) can be used for the diffusion prevention layer 13. In addition to being highly effective in preventing oxygen diffusion, these materials can be formed using general methods such as PVD and CVD. Other materials including silicon oxide (SiO), magnesium oxide (MgO), spinel (MgAl₂O₄), titanium nitride (TiN), tantalum (Ta), tantalum nitride (TaN), tungsten titanium (WTi), tungsten nitride (WN), tungsten boron nitride (WBN), titanium silicon nitride (TiSiN), tungsten silicon nitride (WSiN), aluminum oxide (Al₂O₃), and silicon carbide (SiC) can be used. These can be formed using the PVD method, and depending on the target material for sputtering, the composition may not be stoichiometric.

The second aspect of the cross-sectional structure of the composite substrate according to the present invention is shown in FIG. 2 (composite substrate 2). The composite substrate 2 shown in FIG. 2 has an oxide single crystal thin film 21 on a support substrate 20. The oxide single crystal thin film 21 is bonded to the support substrate 20 via a diffusion prevention layer 23. Here, the diffusion prevention layer 23 has the function of preventing oxygen diffusion as well as an intervening layer.

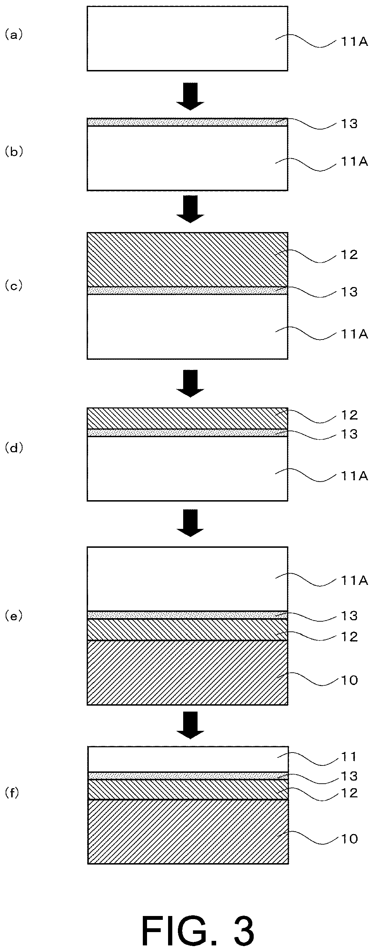

FIG. 3 shows the procedure for manufacturing the composite substrate according to the first aspect. In this manufacturing method, an oxide single-crystal wafer 11A, which is a piezoelectric single crystal substrate, is first prepared ((a) in FIG. 3), and the diffusion prevention layer 13 is formed on one side of the wafer ((b) in FIG. 3). Next, the intervening layer 12 is formed on this diffusion prevention layer 13 ((c) in FIG. 3), and the surface of this intervening layer 12 is polished ((d) in FIG. 3). Then, the polished surface of the intervening layer12 and the support substrate 10 are bonded together ((e) in FIG. 3). After that, the other side (i.e., the side opposite to the side where the diffusion prevention layer 13 was formed) in the oxide single-crystal wafer 11A is ground and polished to thin it to the desired thickness to make the oxide single crystal thin film 11 ((f) in FIG. 3).

At this time, the surface to be bonded may be applied with surface activated treatment in advance. In this way, the bonding strength can be increased. A plasma activation method, an ion beam activation method, and an ozone water activation method can be used for surface activation treatment.

In the plasma activation method, plasma gas is introduced into the reaction vessel in which the wafers are placed, and high-frequency plasma of about 100 W is formed under a reduced pressure of about 0.01-0.1 Pa, exposing the wafer bonding surface to the plasma for about 5-50 seconds. As the gas for plasma, oxygen, hydrogen, nitrogen, argon, or a mixture of these gases can be used.

In the ion beam activation method, a high vacuum of 1×10⁻⁵ Pa or less is created in the reaction vessel, and an ion beam such as argon is applied to the wafer bonding surface and scanned.

In the ozone water activation method, ozone gas is introduced into pure water to make ozone water, and wafers are immersed in this ozone water to activate the bonding surface with active ozone.

### EXAMPLES

### [Example 1]

Approximately 25 nm of SiN was deposited on one side of an LT wafer with a diameter of 150 mm by the PVD method to form a diffusion prevention layer. Then, a silicon oxide film was formed on this diffusion prevention layer by CVD to a thickness of about 3 µm. The silicon oxide film was polished and bonded to a p-type silicon wafer with a resistivity of 2000 Qcm using this silicon oxide film as an intervening layer. The LT wafers used are highly conductive, with bulk conductivity of about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of the bonded substrate manufactured as described above was evaluated by surface potential. The bonded substrate was placed on a hot plate at 250°C for 20 seconds, and then the surface potential was measured, and it was 31V. The higher the surface potential, the higher the pyroelectricity, and if the surface potential is less than 50V, the pyroelectricity is considered to be sufficiently suppressed.

### [Comparative Example 1]

A silicon oxide film was formed on one side of an LT wafer with a diameter of 150 mm by CVD to a thickness of about 3 µm. The silicon oxide film was polished and bonded to a p-type silicon wafer with a resistivity of 2000 Ωcm using this silicon oxide film as an intervening layer. The conductivity of the LT wafers used is about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of the bonded substrate manufactured as described above was evaluated by surface potential. The bonded substrate was placed on a hot plate at 250°C for 20 seconds, and then the surface potential was measured, and it was 2250V.

### [Example 2]

Approximately 25 nm of SiN was deposited on one side of an LT wafer with a diameter of 150 mm by the PVD method to form a diffusion prevention layer. Then, a silicon oxide film was formed on this diffusion prevention layer by CVD to a thickness of about 3 µm. The silicon oxide film was polished and bonded to a p-type silicon wafer with a resistivity of 2000 Ωcm using this silicon oxide film as an intervening layer. Prior to the bonding, the bonding surface was surface activated by the plasma activation method. The LT wafers used are highly conductive, with bulk conductivity of about 4 x 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of the bonded substrate manufactured as described above was evaluated by surface potential. The bonded substrate was placed on a hot plate at 250°C for 20 seconds, and then the surface potential was measured, and it was 32V. Therefore, it was confirmed that the same effect of suppressing pyroelectricity as in Example 1 could be obtained by using the bonding method in which the surface was activated by the plasma activation method.

### [Examples 3, 4]

Approximately 25 nm of SiN diffusion prevention film was deposited on one side of an LT wafer with a diameter of 150 mm by the PVD method to form a diffusion prevention layer. Then, a silicon oxide film was formed on this diffusion prevention layer by CVD to a thickness of about 3 µm. The silicon oxide film was polished, and after surface activation, bonded to a p-type silicon wafer with a resistivity of 2000 Qcm using this silicon oxide film as an intervening layer. Prior to the bonding, the bonding surface was surface activated by various activation methods (ion beam activation method, ozone water activation method). The LT wafers used are highly conductive, with bulk conductivity of about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of each bonded substrate manufactured as described above was evaluated by surface potential. The bonded substrate was placed on a hot plate at 250°C for 20 seconds, and then the surface potential was measured, and it was 31V and 29V, respectively. Therefore, it was confirmed that the effect of suppressing pyroelectricity could be obtained regardless of the type of surface activation method.

### [Examples 5-18]

Approximately 25 nm of the various materials listed in Table 1 were deposited on one side of an LT wafer with a diameter of 150 mm by the PVD method to form a diffusion prevention layer. Then, a silicon oxide film was formed on this diffusion prevention layer by CVD to a thickness of about 3 µm. The silicon oxide film was polished and bonded to p-type silicon wafers with a resistivity of 2000-10000 Ωcm using this silicon oxide film as an intervening layer. The LT wafers used are highly conductive, with bulk conductivity of about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of each bonded substrate manufactured as described above was evaluated by surface potential. The bonded substrate was placed on a hot plate at 250°C for 20 seconds, and then the surface potential was measured. The measurement results are shown in Table 1.

**[Table 1]**

| | Diffusion Prevention Layer | Surface Potential | | Diffusion Prevention Layer | Surface Potential |
|---|---|---|---|---|---|
| Example 5 | SiON | 28V | Example 12 | WTi | 44V |
| Example 6 | SiO | 17V | Example 13 | WN | 47V |
| Example 7 | MgO | 22V | Example 14 | WBN | 29V |
| Example 8 | MgAl₂O₄ | 34V | Example 15 | TiSiN | 38V |
| Example 9 | TiN | 33V | Example 16 | WSiN | 39V |
| Example 10 | Ta | 43V | Example 17 | Al₂O₃ | 15V |
| Example 11 | TaN | 41V | Example 18 | SiC | 21V |

### [Examples 19-21]

Approximately 25 nm of SiN was deposited on one side of an LT wafer with a diameter of 150 mm by PVD or CVD to form a diffusion prevention layer. Then, a silicon oxide film was formed on this diffusion prevention layer by PVD or CVD to a thickness of about 3 µm. The silicon oxide film was polished and bonded to p-type silicon wafers with a resistivity of 2000-10000 Ωcm using this silicon oxide film as an intervening layer. The deposition methods of the diffusion prevention layer and silicon oxide film (intervening layer) in each example are as shown in Table 2. The LT wafers used are highly conductive, with bulk conductivity of about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of each bonded substrate manufactured as described above was evaluated by surface potential. The bonded substrate was placed on a hot plate at 250°C for 20 seconds, and then the surface potential was measured. The measurement results are shown in Table 2. As can be seen from Table 2, it was confirmed that the effect of suppressing pyroelectricity could be obtained regardless of the deposition method.

**[Table 2]**

| | Film Formation Method of Diffusion Prevention Layer | Film Formation Method of Intervening Layer | Surface Potential |
|---|---|---|---|
| Example 19 | PVD | PVD | 28V |
| (Example 1) | PVD | CVD | 31V |
| Example 20 | CVD | PVD | 36V |
| Example 21 | CVD | CVD | 35V |

### [Examples 22-36]

Approximately 3 µm of the various materials listed in Table 3 were deposited on one side of an LT wafer with a diameter of 150 mm by the PVD method to form a diffusion prevention layer. The silicon oxide film was polished bonded to p-type silicon wafers with a resistivity of 2000-10000 Ωcm. The LT wafers used are highly conductive, with bulk conductivity of about 4 × 10⁻¹¹/Ωcm. After the bonding, heat treatment was applied in a nitrogen atmosphere at 100°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of each bonded substrate manufactured as described above was evaluated by surface potential. The bonded substrate was placed on a hot plate at 250°C for 20 seconds, and then the surface potential was measured. The measurement results are shown in Table 3. As can be seen from Table 3, it was confirmed that using the diffusion prevention film itself as an intervening layer had the same effect of suppressing pyroelectricity as providing a separate intervening layer.

**[Table 3]**

| | Diffusion Prevention Layer | Surface Potential | Diffusion | Diffusion Prevention Layer | Surface Potential |
|---|---|---|---|---|---|
| Example 22 | SiN | 27V | Example 30 | WTi | 34V |
| Example 23 | SiON | 22V | Example 31 | WN | 37V |
| Example 24 | SiO | 13V | Example 32 | WBN | 22V |
| Example 25 | MgO | 20V | Example 33 | TiSiN | 26V |
| Example 26 | MgAl₂O₄ | 30V | Example 34 | WSiN | 24V |
| Example 27 | TiN | 28V | Example 35 | Al₂O₃ | 13V |
| Example 28 | Ta | 31V | Example 36 | SiC | 16V |
| Example 29 | TaN | 32V | | | |

### [Examples 37-43]

Approximately 25 nm of SiN was deposited on one side of an LT wafer with a diameter of 150 mm by the PVD method to form a diffusion prevention layer. Then, a silicon oxide film was formed on this diffusion prevention layer by CVD to a thickness of about 3 µm. The silicon oxide film was polished and bonded to silicon wafers on which the thermal oxide film was grown, sapphire wafers, alumina wafers, glass wafers, SiC wafers, AlN wafers, and SiN wafers, respectively, using this silicon oxide film as an intervening layer. Prior to the bonding, the bonding surface was surface activated by the plasma activation method. The LT wafers used are highly conductive, with bulk conductivity of about 4 × 10⁻¹¹/Ωcm. After the bonding, heat treatment was applied in a nitrogen atmosphere at 90°C for 48 hours. The LT layer was then thinned by grinding and polishing to a thickness of 20 µm. Then, to further increase the bonding strength, heat treatment was performed at 250°C for 24 hours in a nitrogen atmosphere.

The pyroelectricity of each bonded substrate manufactured as described above was evaluated by surface potential. The bonded substrate was placed on a hot plate at 250°C for 20 seconds, and then the surface potential was measured. The measurement results are shown in Table 4. As can be seen from Table 4, the effect of suppressing pyroelectricity was observed even if the material of the support substrate was changed.

**[Table 4]**

| | Support Substrate | Surface Potential |
|---|---|---|
| Example 37 | Silicon Wafer on which Thermal Oxide Film was grown | 28V |
| Example 38 | Sapphire Wafer | 22V |
| Example 39 | Alumina Wafer | 23V |
| Example 40 | Glass Wafer | 27V |
| Example 41 | SiC Wafer | 32V |
| Example 42 | AlN Wafer | 30V |
| Example 43 | SiN Wafer | 22V |

### [Example 44]

Experiments corresponding to Examples 1 through 43 were performed using lithium niobate (LN) wafers with a diameter of 100 mm. The results were comparable to those obtained using LT wafers with a diameter of 150 mm, confirming that the effect of this method can be obtained even when LN is used as the oxide single crystal material.

As explained above, by adding the diffusion prevention layer between the LT layer (or LN layer) of the composite substrate and the intervening layer, or by forming the intervening layer with a material that has a diffusion prevention effect, excessive oxygen diffusion into the LT layer (or LN layer) can be prevented, and the increase in pyroelectricity of the LT layer (or LN layer) of the composite substrate can be suppressed.

The present invention is not limited to the above embodiments. The above embodiments are examples only, and any configuration that is substantially the same as the technical concept described in the claims of the present invention and that produces similar effects is included in the technical scope of the present invention.

### Reference Signs List

- 1, 2: Composite substrate (bonded substrate)
- 10, 20: Support substrate
- 11, 21: Oxide single crystal thin film
- 11A: Oxide single crystal wafer
- 12: Intervening layer
- 13, 23: Diffusion prevention layer

## Claims

1. A composite substrate comprising:
an oxide single crystal thin film, which is a single crystal thin film of piezoelectric material;
a support substrate;
a diffusion prevention layer provided between the oxide single crystal thin film and the support substrate to prevent the diffusion of oxygen.

2. The composite substrate according to claim 1, wherein the support substrate contains oxygen.

3. The composite substrate according to claim 1 or 2, comprises an intervening layer containing oxygen between the support substrate and the diffusion prevention layer.

4. The composite substrate according to claim 3, wherein the intervening layer contains any of silicon dioxide, titanium dioxide, tantalum pentoxide, niobium pentoxide, and zirconium dioxide.

5. The composite substrate according to any one of claims 1 to 4, wherein the diffusion prevention layer contains any one of silicon oxynitride, silicon nitride, silicon oxide,
magnesium oxide, spinel, titanium nitride, tantalum, tantalum nitride, tungsten titanium, tungsten nitride, aluminum oxide, silicon carbide, tungsten boron nitride, titanium silicon nitride, and tungsten silicon nitride.

6. The composite substrate according to any one of claims 1 to 5, wherein the piezoelectric material is lithium tantalate or lithium niobate.

7. The composite substrate according to any one of claims 1 to 6, wherein the support substrate is any of a silicon wafer, a sapphire wafer, an alumina wafer, a glass wafer, a silicon carbide wafer, an aluminum nitride wafer, and a silicon nitride wafer.

8. A method of manufacturing composite substrate comprising:
a step of depositing a diffusion prevention layer on one side of a substrate of piezoelectric material;
a step of bonding a support substrate on the diffusion prevention layer; and
a step of thinning the substrate of piezoelectric material by grinding and polishing the other side of the substrate.

9. The method for manufacturing composite substrate according to claim 8, wherein the diffusion prevention layer is deposited by the PVD or CVD method.

10. The method for manufacturing composite substrate according to claim 8 or 9,
further comprising a step of depositing an intervening layer on the bonding surface of the diffusion prevention layer and/or the bonding surface of the support substrate prior to the step of bonding, and
wherein in the step of bonding, the bonding surfaces on which the intervening layer has been deposited are bonded together

11. The method for manufacturing composite substrate according to any one of claims 8 to 10, wherein the bonding surface of the diffusion prevention layer and/or the bonding surface of the support substrate are applied with surface activation treatment and then bonded to each other.

12. The method for manufacturing composite substrate according to claims 11, wherein the surface activation treatment includes any one of a plasma activation method, an ion beam activation method, and an ozone water activation method.
